# EUROPEAN PATENT APPLICATION

(11) **EP 4 852 669 A1**
(43) Date of publication of application: **09.12.2026**
(21) Application number: 25196426.8
(22) Date of filing: 18.08.2025
(51) Int. Cl.: H10F 77/20

(54) **SOLAR CELL AND MANUFACTURING METHOD THEREOF, TANDEM SOLAR CELL, AND PHOTOVOLTAIC MODULE**

(30) Priority: 06.06.2025 CN 202510756745
(71) Applicant: Zhejiang Jinko Solar Co., Ltd., Haining, Zhejiang (CN)
(72) Inventor: ZHAO, Xiangyun, Haining (CN); YU, Ding, Haining (CN); LI, Wenqi, Haining (CN); YANG, Jie, Haining (CN); ZHENG, Peiting, Haining (CN); ZHANG, Xinyu, Haining (CN)
(74) Representative: Balder IP Law, S.L.

(57) **Abstract**

Embodiments of the present disclosure relate to the field of photovoltaic technology, and provide a solar cell, a method for manufacturing solar cells, a tandem solar cell, and a photovoltaic module. The solar cell includes: a substrate including a first surface and a second surface opposite to each other, and grid lines arranged at intervals on at least one of the first surface and the second surface along a first direction. Each grid line includes a respective contact structure and a respective connection layer that are in electrical connection to the substrate, the respective contact structure includes a plurality of contact portions, the respective connection layer is an elongated strip structure extending along the second direction. The plurality of contact portions include first contact portions and second contact portions alternately arranged along the second direction, and the respective connection layer includes a first side portion and a second side portion extending along the second direction. The first contact portions are in electrical connection to at least the first side portion and the second contact portions are in electrical connection to the second side portion, or the second contact portions are in electrical connection to at least the second side portion and the first contact portions are in electrical connection to the first side portion. The solar cell is at least conducive to improving the performance of electrical connection between the grid lines and the substrate, and to reducing the manufacturing cost of the grid lines.

## Description

### TECHNICAL FIELD

The present disclosure relates to the technical field of photovoltaic technology, and in particular to a solar cell, a method for manufacturing solar cells, a tandem solar cell, and a photovoltaic module.

### BACKGROUND

With the gradual depletion of fossil energy, solar cells are used more and more widely as a new energy alternative. The solar cell is a device for converting solar light energy into electric energy. The solar cell generates carriers by utilizing the photovoltaic principle, and carriers are led out by grid lines, thereby effectively utilizing the electric energy. At present, solar cells mainly include back contact (BC) solar cells, tunnel oxide passivated contact (TOPCON) solar cells, passivated emitter and rear cells (PERC), and heterojunction solar cells.

### SUMMARY

Embodiments of the present disclosure provide a solar cell, a method for manufacturing solar cells, a tandem solar cell, and a photovoltaic module, which are at least conducive to improving the performance of electrical connection between grid lines and substrate of a solar cell, and to reducing the manufacturing cost of grid lines.

In one aspect, some embodiments of the present disclosure provide a solar cell, including: a substrate including a first surface and a second surface opposite to each other and each substantially perpendicular to a thickness direction of the substrate, and grid lines arranged at intervals on at least one of the first surface and the second surface along a first direction. Each grid line of at least some of the grid lines includes a respective contact structure and a respective connection layer that are electrically connected to the substrate, the respective contact structure includes a plurality of contact portions arranged at intervals along a second direction, the respective connection layer is an elongated strip structure extending along the second direction, and the first direction intersects with the second direction. The respective connection layer is electrically connected to the plurality of contact portions and includes a material that is different from a material of the plurality of contact portions, and an orthographic projection of the respective connection layer on the substrate partially overlaps with orthographic projections of the plurality of contact portions on the substrate. The plurality of contact portions include first contact portions and second contact portions alternately arranged along the second direction, and the respective connection layer has a first side extending along the second direction, an opposing second side extending in the second direction, a first side portion extending along the second direction on the first side, and a second side portion extending along the second direction on the second side. The first contact portions traverse at least the first side portion, and the second contact portions traverse at least the second side portion.

In some embodiments, in the second direction, the first contact portions are unaligned with the second contact portions.

In some embodiments, in the second direction, segments of the first contact portions are aligned with segments of the second contact portions.

In some embodiments, one respective first contact portion of the first contact portions includes a first segment that is aligned with the segments of the second contact portions in the second direction, and a segment of the respective first contact portion other than the first segment has a width less than or equal to 25 µm in the first direction.

In some embodiments, the orthographic projections of the plurality of contact portions on the substrate have shapes of circles, ellipses, triangles, rectangles, trapezoids, or N-sided polygons, wherein N is a positive integer greater than 4.

In some embodiments, the orthographic projections of the plurality of contact portions on the substrate have shapes of circles or ellipses, and one respective first contact portion of the first contact portions is tangential to a second contact portion of the second contact portions adjacent to the respective first contact portion in the second direction.

In some embodiments, an orthographic projection of one respective contact portion of the plurality of contact portions on the substrate has an area ranged from 100µm2 to 5000µm2.

In some embodiments, the respective connection layer has a width ranged from 10µm to 70µm in the first direction.

In some embodiments, in the second direction, a distance between one respective first contact portion of the first contact portions and a second contact portion of the second contact portions adjacent to the respective first contact portion is less than or equal to 200µm.

In some embodiments, in the thickness direction, the plurality of contact portions have thicknesses ranged from 1µm to 10µm, and/or the respective connection layer has a thickness ranged from 4µm to 20µm.

In some embodiments, the solar cell includes finger electrodes and busbars. The grid lines are finger electrodes, and the busbars are in a form of elongated strip structures extending along the first direction; or the grid lines are busbars, and the finger electrodes are in a form of elongated strip structures extending along the first direction.

In some embodiments, the grid lines are finger electrodes, and the solar cell further includes: busbars arranged at intervals on at least one of the first surface and the second surface along the second direction. Each busbar of at least some of the busbars includes a respective connection structure and a respective interconnection layer that are electrically connected to the substrate, the respective connection structure includes a plurality of connection portions arranged at intervals along the first direction, and the respective interconnection layer is an elongated strip structure extending along the first direction. The respective interconnection layer is electrically connected to the plurality of connection portions, the plurality of connection portions include first connection portions and second connection portions alternately arranged along the second direction, and the respective interconnection layer has a third side extending along the second direction, an opposing fourth side extending in the second direction, a third side portion extending along the second direction on the third side, and a fourth side portion extending along the second direction on the fourth side. The first connection portions traverses at least the third side portion, the second connection portions traverses at least the fourth side portion, and a material of the plurality of connection portions is different from a material of the respective interconnection layer.

In some embodiments, the plurality of contact portions includes silver particles, and the respective connection layer includes copper particles or silver-coated copper particles.

In some embodiments, the copper particles have diameters ranged from 50nm to 1500nm, or the silver-coated copper particles have diameters ranged from 1 µm to 10µm, or a proportion of silver in the silver-coated copper particles ranges from 15% to 50%.

In another aspect, some embodiments of the present disclosure provide a method for manufacturing solar cells, including: providing a substrate including a first surface and a second surface, where the first surface and the second surface are opposite to each other and each substantially perpendicular to a thickness direction of the substrate; and forming grid lines arranged at intervals on at least one of the first surface and the second surface along a first direction. Each grid line of at least some of the grid lines includes a respective contact structure and a respective connection layer that are electrically connected to the substrate, the respective contact structure includes a plurality of contact portions arranged at intervals along a second direction, the respective connection layer is an elongated strip structure extending along the second direction, and the first direction intersects with the second direction. The respective connection layer is electrically connected to the plurality of contact portions and includes a material that is different from a material of the plurality of contact portions, and an orthographic projection of the respective connection layer on the substrate partially overlaps with orthographic projections of the plurality of contact portions on the substrate. The plurality of contact portions include first contact portions and second contact portions alternately arranged along the second direction, and the respective connection layer has a first side extending along the second direction, an opposing second side extending in the second direction, a first side portion extending along the second direction on the first side, and a second side portion extending along the second direction on the second side. The first contact portions traverses at least the first side portion, and the second contact portions traverses at least the second side portion.

In some embodiments, the grid lines are finger electrodes, and the second surface includes first printing areas and second printing areas that partially overlap with the first printing areas. Forming the grid lines, includes: printing first paste on the first printing areas using a first screen printing process; performing sintering on the first paste to form the respective contact structure on the first printing areas; printing second paste on the second printing areas using a second screen printing process; and curing the second paste to form the respective connection layer on the second printing areas. The first paste is firing-through paste, the second paste is non-firing paste, and a process temperature for performing the sintering is greater than a process temperature for curing.

In some embodiments, the first paste is silver paste, and the second paste is copper paste or silver-coated copper paste.

In some embodiments, a solid content in the silver paste ranges from 75% to 92%.

In some embodiments, the second surface further includes third printing areas. The method further includes: printing the first paste on the third printing areas using the first screen printing process, and performing the sintering on the first paste to form busbars on the third printing areas; or printing the second paste on the third printing areas using the second screen printing process, and curing the second paste to form the busbars on the third printing areas.

In some embodiments, the finger electrodes formed on the second surface are back finger electrodes, the busbars formed on the second surface are back busbars, and the first surface includes fourth printing areas extending along the first direction and fifth printing areas extending along the second direction. Before performing the sintering, the method further includes: printing third paste on the fourth printing areas using a third screen printing process; and printing fourth paste on the fifth printing areas using a fourth screen printing process. Performing the sintering, includes: performing the sintering on the third paste to form front finger electrodes on the fourth printing areas; and performing the sintering on the fourth paste to form front busbars on the fifth printing areas.

In still another aspect, some embodiments of the present disclosure provide a tandem solar cell, including: a bottom solar cell and a top solar cell arranged on a side of the bottom solar cell. The bottom solar cell includes the solar cell as illustrated above, or the bottom solar cell is manufactured using the method as illustrated above.

In yet another aspect, some embodiments of the present disclosure provide a photovoltaic module, including: at least one solar cell string, where the at least one solar cell string is formed by connecting a plurality of solar cells as illustrated above, or formed by connecting a plurality of solar cells manufactured using the method as illustrated above, or formed by connecting a plurality of tandem solar cells as illustrated above; at least one packaging adhesive film configured to cover a surface of the at least one solar cell string; and at least one cover plate configured to cover a surface of the at least one packaging adhesive film away from the at least one solar cell string.

### BRIEF DESCRIPTION OF THE DRAWINGS

Exemplary illustrations of one or more embodiments are provided by reference to pictures in the corresponding accompanying drawings. These exemplary illustrations do not constitute a limitation on the embodiments. The drawings do not constitute a scale limitation unless otherwise specified. In order to illustrate the technical solutions in related technologies or in the embodiments of the present disclosure more clearly, the drawings to be used in the embodiments will be briefly described below. It is obvious that the drawings mentioned in the following illustration are only some embodiments of the present disclosure. For those of ordinary skill in the art, other drawings may also be obtained in accordance with these drawings without any inventive effort.
FIG. 1 is a schematic top view of a portion of a first grid line of a solar cell provided in some embodiments of the present disclosure;
FIG. 2 is a schematic top view of a portion of a solar cell provided in some embodiments of the present disclosure;
FIG. 3 is a schematic cross-sectional view taken along a first sectional direction AA1 in FIG. 2;
FIG. 4 is a schematic top view of a portion of a second grid line of the solar cell provided in some embodiments of the present disclosure;
FIG. 5 is a schematic top view of a portion of a third grid line of the solar cell provided in some embodiments of the present disclosure;
FIG. 6 is a schematic top view of a portion of a fourth grid line of the solar cell provided in some embodiments of the present disclosure;
FIG. 7 is a schematic top view of a portion of a fifth grid line of the solar cell provided in some embodiments of the present disclosure;
FIG. 8 is a partially enlarged schematic diagram of two adjacent contact portions of the solar cell provided in some embodiments of the present disclosure;
FIG. 9 is a schematic top view of a portion of a sixth grid line of the solar cell provided in some embodiments of the present disclosure;
FIG. 10 is a schematic top view of a portion of a seventh grid line of the solar cell provided in some embodiments of the present disclosure;
FIG. 11 is a schematic top view of a portion of an eighth grid line of the solar cell provided in some embodiments of the present disclosure;
FIG. 12 is a schematic top view of a portion of another solar cell provided in some embodiments of the present disclosure;
FIG. 13 is a schematic top view of a portion of a busbar of the solar cell provided in some embodiments of the present disclosure;
FIG. 14 is a schematic cross-sectional view of a portion of a tandem solar cell provided in some embodiments of the present disclosure;
FIG. 15 is a schematic perspective view of a portion of a cell string of a photovoltaic module provided in some embodiments of the present disclosure; and
FIG. 16 is a schematic cross-sectional view of a portion of the photovoltaic module provided in some embodiments of the present disclosure.

Description of reference numerals:
100, substrate; 110, first surface; 120, second surface; 101, grid line; 102, contact structure; 112, contact portion; 122, first contact portion; 122a, the first edge; 1221, first segment; 1222, second segment; 132, second contact portion; 132a, second edge; 103, connection layer; 113, first side portion; 123, second side portion; 104, finger electrode; 105, busbar; 115, connection structure; 125, interconnection layer; 135, connection portion; 145, first connection portion; 155, second connection portion; 165, third side portion; 175, fourth side portion; 106, bottom solar cell; 107, top solar cell; 40, solar cell; 41, packaging adhesive film; 42, cover plate; 43, conductive strip.

### DETAILED DESCRIPTION OF THE EMBODIMENTS

It is found by analysis that for either solar cells having grid lines formed on both surfaces or back contact solar cells having grid lines formed on a single surface, a process for forming grid lines consumes a large amount of silver paste for printing, resulting in high costs for metallization and a need to reduce the manufacturing cost of grid lines. Moreover, compared to solar cells having grid lines formed on both surfaces, back contact solar cells having grid lines formed on a single surface require a larger amount of silver paste.

In practice, for solar cells having grid lines formed on both surfaces, for example TOPCON solar cells, the amount of silver paste used for a solar cell is up to 80mg, and the amount of silver paste used for a single surface of the solar cell is up to 40mg.

In the solar cell, the method for manufacturing solar cells, the tandem solar cell, and the photovoltaic module provided in the embodiments of the present disclosure, the first contact portions are electrically connected to at least the first side portion and the second contact portions are electrically connected to the second side portion, or the second contact portions are electrically connected to at least the second side portion and the first contact portions are electrically connected to the first side portion, such that one respective first contact portion of the first contact portions can be unaligned, in the first direction, with a second contact portion adjacent to the respective first contact portion in the second direction. Thus, on the one hand, with the dimension of the respective connection layer being unchanged, the arrangement in which the first contact portions are unaligned with the second contact portions is conducive to reduction of materials consumption of the respective contact structure while ensuring sufficient contact areas between the respective contact structure and respective connection layer, compared with manufacturing the respective contact structure to have an elongated strip structure similar to the respective connection layer, which is conducive to improving the performance of electrical connection between the grid lines and the substrate, and to reducing the manufacturing cost of the grid lines. On the other hand, the arrangement in which the first contact portions are unaligned with the second contact portions is conducive to increasing a maximum distance between an edge of one respective first contact portion of the first contact portions and an edge of one respective second contact portion of the second contact portions in the first direction, which, with the dimension of the respective connection layer being unchanged, is conducive to reducing the requirement for alignment accuracy between the respective contact structure and the respective connection layer, compared with manufacturing the respective contact structure to have an elongated strip structure similar to the respective connection layer. In this way, the difficulty of manufacturing the respective connection layer and therefore the difficulty of manufacturing the grid lines can be reduced, while the good performance of the electrical contact between the respective contact structure and respective connection layer can be ensured. Moreover, due to the fact that the material of the plurality of contact portions is different from the material of the respective connection layer, the manufacturing cost of the respective contact structure can be further reduced by adjusting the material of the plurality of contact portions and the material of the respective connection layer.

In the description of the embodiments of the present disclosure, the technical terms "first", "second", and the like are merely intended to distinguish different objects, and shall not be understood as an indication or implication of relative importance or implicit indication of the number, specific sequence, or dominant-subordinate relationship of the technical features indicated. In the description of the embodiments of the present disclosure, "a plurality of" means two or more, unless otherwise specifically stated.

The phrase "embodiment" described herein means that specific features, structures, or characteristics described in combination with the embodiments may be incorporated in at least one embodiment of the present disclosure. This phrase appearing at various positions of the specification do not necessarily refer to either the same embodiment or separate or alternative embodiments that are mutually exclusive with other embodiments. It is explicitly and implicitly understood by those skilled in the art that the embodiments described herein may be combined with other embodiments.

In the description of the embodiments of the present disclosure, the term "and/or" herein is merely an association relationship describing associated objects, indicating that three relationships may exist. For example, A and/or B indicates that there are three cases of A alone, A and B together, and B alone. In addition, the character "/" herein generally indicates an "or" relationship between the associated objects.

In the description of the embodiments of the present disclosure, "a plurality of" means two or more (including two). Similarly, "a plurality of groups" means two or more groups (including two groups), and "a plurality of pieces" means two or more pieces (including two pieces).

In the description of the embodiments of the present disclosure, the orientation or position relationships indicated by the technical terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", and the like are based on the orientation or position relationships shown in the accompanying drawings and are intended to facilitate the description of the present disclosure and simplify the description only, rather than indicating or implying that the apparatus or element referred to must have a particular orientation or be constructed and operated in a particular orientation, and therefore are not to be interpreted as limiting the embodiments of the present disclosure.

In the illustration of the embodiments of the present disclosure, unless otherwise specified and limited, technical terms such as "installation", "coupling", "connection", or "fixation" should be broadly understood. For example, "connection" may refer to fixed connections, detachable connections, integrated as a whole, mechanical connections or electrical connections, direct connections or indirect connections through an intermediate medium, or internal connections between two components or an interaction relationship between two components. For those skilled in the art, the specific meanings of the above terms in the embodiments of the present disclosure shall be understood according to the specific situations.

In the drawings corresponding to the embodiments of the present disclosure, for better understanding and ease of description, a thickness and an area of a layer are exaggerated. When a component is described as being on the other component or on a surface of the other component, the component may be "directly" on the surface of the other component or there may be a third component between the two components. In contrast, when one component is described as being at the surface of the other component or the other component is formed at or provided at a surface of one component, there is no third component between the two components. In addition, when a component is described as being "substantially" formed on the other component, it indicates that the component is neither formed on the entire surface (or a front surface) of the other component, nor formed on part of an edge of the entire surface.

In the description of the embodiments of the present disclosure, when a component "includes" another component, other components are not excluded and may further be included unless otherwise stated. In addition, when components such as layers, films, regions, or plates are referred to as being "on/located on" another component, they may be "directly on" another component (i.e. there is no other components between them) or there may be other components present therebetween. Moreover, when a component such as a layer, a film, a region, or a plate is "directly on" another component, or the component such as a layer, a film, a region, or a plate is at a surface of another component, it indicates that there are no other components between them.

The terms used in the description of the embodiments herein are for describing particular embodiments only and not intended to be limiting. As used in the description of the embodiments described and in the appended claims, "the component" is also intended to include the plural form unless the context clearly indicates otherwise. Herein, a component includes a layer, a film, a region, a plate, or the like.

Various embodiments of the present disclosure will be described in detail below with reference to the accompanying drawings. However, those of ordinary skill in the art shall understand that in the embodiments of the present disclosure, many technical details are provided to enable readers to better understand the embodiments of the present disclosure. However, even without these technical details and various changes and modifications based on the following embodiments, the claimed technical solutions of the present disclosure can still be implemented.

Some embodiments of the present disclosure provide a solar cell. In the following, a detailed illustration of the solar cell will be provided in conjunction with the accompanying drawings.

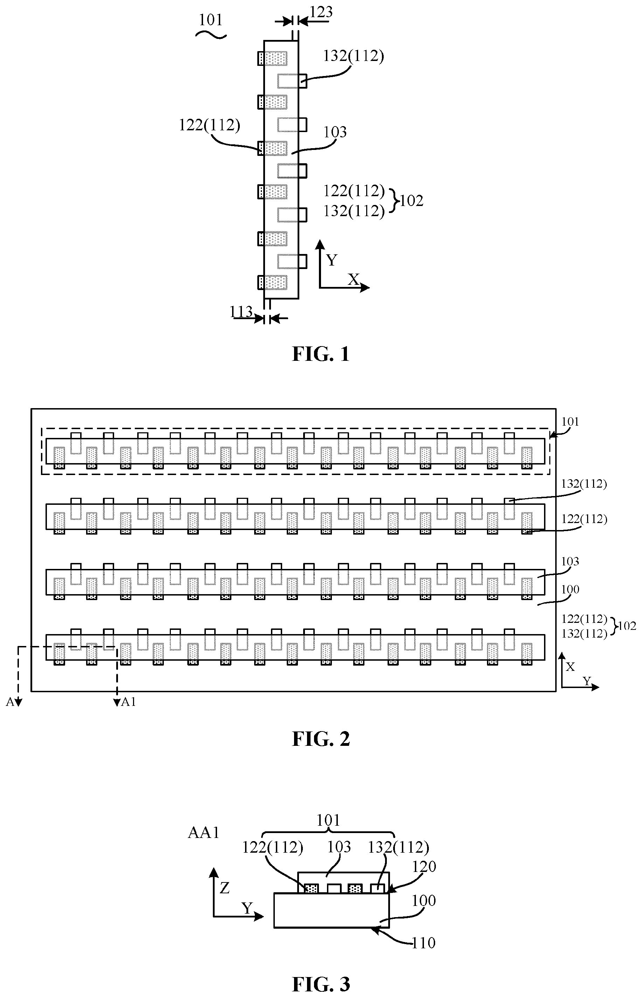

Referring to FIGS. 1 to 7, the solar cell includes: a substrate 100 including a first surface 110 and a second surface 120 opposite to each other and each substantially perpendicular to a thickness direction Z of the substrate 100, and grid lines 101 arranged at intervals on at least one of the first surface 110 and the second surface 120 along a first direction X. Each grid line of at least some of the grid lines 101 includes a respective contact structure 102 and a respective connection layer 103 that are electrically connected to the substrate 100, the respective contact structure 102 includes a plurality of contact portions 112 arranged along a second direction Y, the respective connection layer 103 is an elongated strip structure extending along the second direction Y, and the first direction X intersects with the second direction Y. The respective connection layer 103 is electrically connected to the plurality of contact portions 112, a material of the plurality of contact portions 112 is different from a material of the respective connection layer 103, and an orthographic projection of the respective connection layer 103 on the substrate partially overlaps with orthographic projections of the plurality of contact portions 112 on the substrate. The plurality of contact portions 112 include first contact portions 122 and second contact portions 132 alternately arranged along the second direction Y, and the respective connection layer 103 includes a first side portion 113 and a second side portion 123 extending along the second direction Y. The first contact portions 122 are electrically connected to at least the first side portion 113, and the second contact portions 132 are electrically connected to at least the second side portion 123.

Herein, the phrase "substantially perpendicular to" refers to that each of the first surface 110 and the second surface 120 may be strictly perpendicular to the thickness direction Z of the substrate 100, or an included angle between the thickness direction Z and each of the first surface 110 and the second surface 120 may be slightly greater than or less than a right angle, for example, the included angle may be 87°, 88°, 89°, 91°, 92°, 93°, or the like.

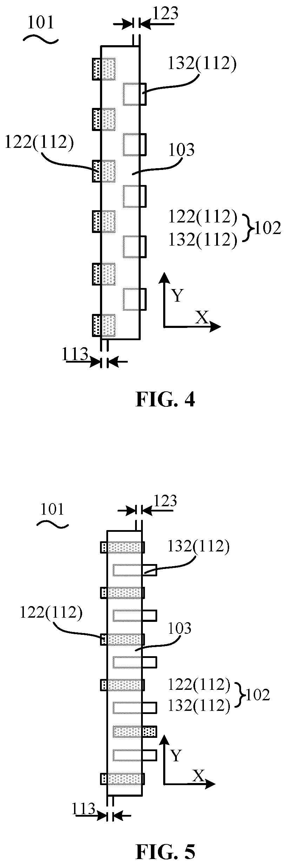

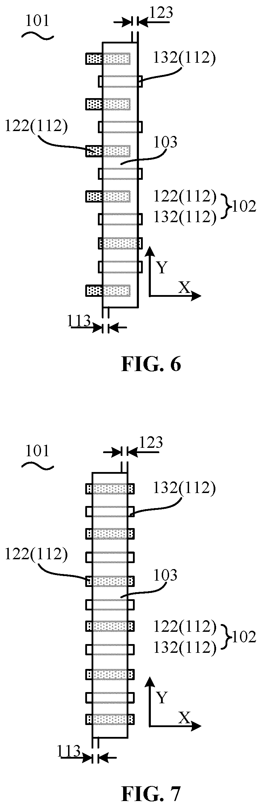

FIG. 1 is a schematic top view of a portion of a first grid line of a solar cell provided in some embodiments of the present disclosure. FIG. 2 is a schematic top view of a portion of a solar cell provided in some embodiments of the present disclosure. FIG. 3 is a schematic cross-sectional view taken along a first sectional direction AA1 in FIG. 2. FIG. 4 is a schematic top view of a portion of a second grid line of the solar cell provided in some embodiments of the present disclosure. FIG. 5 is a schematic top view of a portion of a third grid line of the solar cell provided in some embodiments of the present disclosure. FIG. 6 is a schematic top view of a portion of a fourth grid line of the solar cell provided in some embodiments of the present disclosure. FIG. 7 is a schematic top view of a portion of a fifth grid line of the solar cell provided in some embodiments of the present disclosure.

It is noted that in order to clearly illustrate the positional relationship between the respective connection layer 103 and the plurality of contact portions 112, both FIG. 1 and FIG. 2 use a perspective drawing method for the respective connection layer 103. In addition, FIG. 1 is only an example of a positional relationship between the respective connection layer 103 and the plurality of contact portions 112, and further detailed illustration of the positional relationship between the respective connection layer 103 and the plurality of contact portions 112 will be provided in conjunction with other drawings. In FIG. 3, the grid lines 101 is exemplarily shown as being formed on the second surface 120. In practice, the grid lines may be formed on the first surface, or may be formed on both the first and second surfaces.

It is noted that in some embodiments, referring to FIG. 1, FIG. 4, FIG. 5, or FIG. 6, the first contact portions 122 are electrically connected to at least the first side portion 113, and the second contact portions 132 are electrically connected to at least the second side portion 123, such that one respective first contact portion of the first contact portions 122 can be unaligned, in the first direction X, with a second contact portion 132 adjacent to the respective first contact portion 122 in the second direction Y. Herein, the first contact portions 122 are electrically connected to at least the first side portion 113 and the second contact portions 132 are electrically connected to the second side portion 123, or the second contact portions 132 are electrically connected to at least the second side portion 123 and the first contact portions 122 are electrically connected to the first side portion 113. Detailed illustration of the positional relationship between the respective connection layer 103 and the plurality of contact portions 112 of the respective contact structure 102 will be provided in the following.

Thus, on the one hand, with the dimension of the respective connection layer 103 being unchanged, the arrangement in which the first contact portions 122 are unaligned with the second contact portions 132 is conducive to reduction of materials consumption of the respective contact structure 102 while ensuring sufficient contact areas between the respective contact structure 102 and the respective connection layer 103, compared with manufacturing the respective contact structure to have an elongated strip structure similar to the respective connection layer 103, which is conducive to improving the performance of electrical connection between the grid lines 101 and the substrate 100, and to reducing the manufacturing cost of the grid lines 101. On the other hand, in the first direction X, each first contact portion 122 has a respective third edge away from the second contact portions 132, and each second contact portion 132 has a respective fourth edge away from the first contact portions 122, the arrangement in which the first contact portions 122 are unaligned with the second contact portions 132 is conducive to increasing a maximum distance between the respective third edge and the respective fourth edge in the first direction X, which, with the dimension of the respective connection layer 103 being unchanged, is conducive to reducing the requirement for alignment accuracy between the respective contact structure 102 and the respective connection layer 103, compared with manufacturing the respective contact structure to have an elongated strip structure similar to the respective connection layer 103. In other words, the arrangement in which the first contact portions 122 are unaligned with the second contact portions 132 allows for a larger offset error between the respective contact structure 102 and the respective connection layer 103 in the first direction X, and as long as an error is not larger than this offset error, the contact area between the respective connection layer 103 and the respective contact structure 102 is unchanged. In this way, the difficulty of manufacturing the respective connection layer 103 and therefore the difficulty of manufacturing the grid lines 101 can be reduced, while the good performance of the electrical contact between the respective contact structure 102 and the respective connection layer 103 can be ensured.

In some embodiments, referring to FIG. 1, FIG. 4, or FIG. 5, the first contact portions 122 are electrically connected to at least the first side portion 113, and the second contact portions 132 are electrically connected only to the second side portion 123 and are not electrically connected to the first side portion 113.

In some other embodiments, referring to FIG. 1, FIG. 4, or FIG. 6, the second contact portions 132 are electrically connected at least to the second side portion 123, and the first contact portions 122 are electrically connected to only the first side portion 113 and are not electrically connected to the second side portion 123.

In some other embodiments, referring to FIG. 7, the first contact portions 122 are electrically connected to at least the first side portion 113, the second contact portions 132 are electrically connected at least to the second side portion 123, and the first contact portions 122 and the second contact portions 132 are arranged to space apart from each other along the second direction Y. Specifically, each first contact portion 122 is electrically connected to both the first side portion 113 and the second side portion 123, and each second contact portion 132 is electrically connected to both the first side portion 113 and the second side portion 123. In this way, with the dimension of the respective connection layer 103 being unchanged, the arrangement in which the first contact portions 122 and the second contact portions 132 are arranged to space apart from each other along the second direction Y is conducive to reduction of materials consumption of the respective contact structure 102 while ensuring sufficient contact areas between the respective contact structure 102 and the respective connection layer 103, compared with manufacturing the respective contact structure to have an elongated strip structure similar to the respective connection layer 103, which is conducive to improving the performance of electrical connection between the grid lines 101 and the substrate 100, and to reducing the manufacturing cost of the grid lines 101.

Moreover, the material of the plurality of contact portions 112 is different from the material of the respective connection layer 103, thereby prevent the grid lines 101 from being manufactured using a same material. By adjusting the material of the plurality of contact portions 112 and the material of the respective connection layer 103, for example the material of the respective connection layer 103 is adjusted to have a cost lower than a cost of the material of the plurality of contact portions 112, in addition to the reduction of the manufacturing cost of the respective contact structure 102 resulted from reducing the amount of material required for the respective contact structure 102 by designing the plurality of contact portions 112 to be dispersed, the manufacturing cost of the respective contact structure 102 can be further reduced due to reduction in the cost of the material of the respective connection layer 103.

It is noted that in some embodiments, referring to FIGS. 1 to 7, for a single grid line 101, the connection layer 103 may be electrically connected to each contact portion 112 of the contact structure 102. In practice, due to the limitations in printing technology, when the orthographic projection of the connection layer on the substrate is overlapped with a respective orthographic projection of each contact portion, poor electrical connection(s) may occur between the connection layer and individual contact portion(s), such as in a case where significant errors in the printing thickness of individual contact portion(s) occur or significant errors in the printing thickness of some areas of the connection layer occur. Alternatively, due to limitations in printing technology, when a finally formed pattern of individual contact portion(s) differs significantly from a designed pattern, poor electrical connection(s) may also occur between the connection layer and individual contact portion(s).

In the following, a more detailed illustration of the solar cell provided in some embodiments of the present disclosure will be provided in conjunction with the accompanying drawings.

In some embodiments, referring to FIG. 4, for a grid line 101, the first contact portions 122 are unaligned with the second contact portions 132 in the second direction Y. In other words, orthographic projections of the first contact portions 122 on a plane perpendicular to the second direction Y and orthographic projections of the second contact portions 132 on the plane perpendicular to the second direction Y do not overlap with each other.

In this case, the connection between the plurality of contact portions 112 and the connection layer 103 is as follows: the first contact portions 122 are only electrically connected to the first side portion 113, and the second contact portions 132 are only electrically connected to the second side portion 123.

In some other embodiments, referring to FIG. 1, FIG. 5, or FIG. 6, for a grid line 101, segments of the first contact portions 122 are aligned with segments of the second contact portions 132 in the second direction Y. In other words, orthographic projections of the first contact portions 122 on the plane perpendicular to the second direction Y partially overlap with orthographic projections of the second contact portions 132 on the plane perpendicular to the second direction Y.

In this case, the connection between the plurality of contact portions 112 and the connection layer 103 includes at least three arrangements as follows.

Arrangement one: referring to FIG. 1, the first contact portions 122 are only electrically connected to the first side portion 113, and the second contact portions 132 are only electrically connected to the second side portion 123. It is noted that in order to reduce the dimension of the contact portions 112 to lower the manufacturing cost and increase the contact area between the contact portions 112 and the connection layer 103, compared with the contact portions 112 shown in FIG. 4, the contact portions 112 shown in FIG. 1 may have larger widths in the first direction X, and have smaller extension lengths in the second direction Y, thereby ensuring as much as possible that more than half of the area of the contact structure 102 can be electrically connected to the connection layer 103.

Arrangement two: referring to FIG. 5, the first contact portions 122 are electrically connected to both the first side portion 113 and the second side portion 123, and the second contact portions 132 are only electrically connected to the second side portion 123. It is noted that in order to reduce the dimension of the contact portions 112 to lower the manufacturing cost and increase the contact area between the contact portions 112 and the connection layer 103, in the first direction X, a first contact portion 122 may have a width larger than a width of a second contact portion 132, thereby ensuring as much as possible that more than half of the area of the contact structure 102 can be electrically connected to the connection layer 103. Moreover, compared with the contact portions 112 shown in FIG. 1, the contact portions 112 shown in FIG. 5 may have larger widths in the first direction X, and have smaller extension lengths in the second direction Y, in order to reduce the amount of material required for the contact structure 102 as much as possible.

Arrangement three: referring to FIG. 6, the first contact portions 122 are only electrically connected to the first side portion 113, and the second contact portions 132 are electrically connected to both the first side portion 113 and the second side portion 123. It is noted that in order to reduce the dimension of the contact portions 112 to lower the manufacturing cost and increase the contact area between the contact portions 112 and the connection layer 103, in the first direction X, a second contact portion 132 may have a width larger than a width of a first contact portion 122, thereby ensuring as much as possible that more than half of the area of the contact structure 102 can be electrically connected to the connection layer 103. Moreover, compared with the contact portions 112 shown in FIG. 1, the contact portions 112 shown in FIG. 6 may have larger widths in the first direction X, and have smaller extension lengths in the second direction Y, in order to reduce the amount of material required for the contact structure 102 as much as possible.

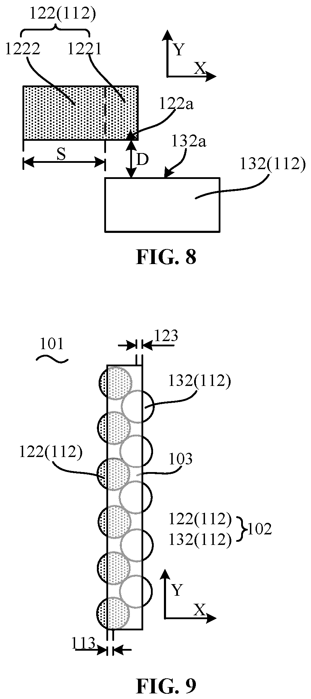

For the above-mentioned three arrangements, referring to FIG. 8, FIG. 8 is a partially enlarged schematic diagram of two adjacent contact portions of the solar cell provided in some embodiments of the present disclosure. One respective first contact portion of the first contact portions 122 includes a first segment 1221 that is aligned with the segments of the second contact portions 132 in the second direction Y, and a segment of the respective first contact portion 122 other than the first segment 1221 has a width S less than or equal to 25µm in the first direction X. In other words, a misalignment range between a first contact portion 122 and a second contact portion 132 adjacent to the first contact portion 122 in the second direction Y is less than or equal to 25µm, for example, it may be 24µm, 23µm, 22µm, 21µm, 20µm, 19µm, 18µm, 17µm, 16µm, 15µm, 14µm, 13µm, 12µm, 11µm, 10µm, 9µm, 8µm, 7µm, 6µm, 5µm, 4µm, 3µm, 2µm, 1µm, or the like.

The segment of the respective first contact portion 122 other than the first segment 1221 may be referred to as a second segment 1222, and the second segment 1222 has a width S less than or equal to 25µm in the first direction X. In FIG. 8, the first contact portion 122 is divided into the first segment 1221 and the second segment 1222 by a dashed line.

It is noted that when the first segments of the first contact portions 122 are aligned with the segments of the second contact portions 132 in the second direction Y and the widths S of the second segments 1222 in the first direction X are greater than 25µm, a degree of misalignment between a first contact portion 122 and a second contact portion 132 adjacent to this first contact portion in the first direction X is relatively large, and a distance between the third edge and the fourth edge in the first direction X is too large, which is not conducive to ensuring a large contact area between the connection layer 103 and the contact structure 102, with the dimension of the connection layer 103 remains unchanged. Thus, the misalignment range between a first contact portion 122 and a second contact portion 132 adjacent to this first contact portion in the second direction Y is set to be less than or equal to 25µm, which is conducive to providing an appropriate degree of misalignment between a first contact portion 122 and a second contact portion 132 adjacent to this first contact portion in the first direction X, thereby reducing the dimensions of the contact portions 112 as much as possible, and ensuring as much as possible that more than half of the area of the contact structure 102 can be electrically connected to the connection layer 103.

In some other embodiments, referring to FIG. 7, for a grid line 101, the first contact portions 122 are aligned with the second contact portions 132 in the second direction Y. In other words, orthographic projections of the first contact portions 122 on the plane perpendicular to the second direction Y are overlapped with orthographic projections of the second contact portions 132 on the plane perpendicular to the second direction Y. That is, the misalignment range between a first contact portion 122 and a second contact portion 132 adjacent to this first contact portion in the second direction Y is 0.

In this case, the connection between the plurality of contact portions 112 and the connection layer 103 is as follows: the first contact portions 122 are electrically connected to both the first side portion 113 and the second side portion 123, and the second contact portions 132 are electrically connected to both the first side portion 113 and the second side portion 123.

In the following, detailed illustration of the plurality of contact portions 112 will be provided.

In some embodiments, referring to FIGS. 1 to 8, the orthographic projections of the plurality of contact portions 112 on the substrate 100 may have shapes of rectangles.

In some other embodiments, referring to FIG. 9, FIG. 9 is a schematic top view of a portion of a sixth grid line of the solar cell provided in some embodiments of the present disclosure, the orthographic projections of the plurality of contact portions 112 on the substrate 100 may have shapes of circles. It is noted that due to limitation in accuracy of the process for forming the plurality of contact portions 112, when the orthographic projections of the plurality of contact portions 112 on the substrate 100 have shapes of circles, the circles may also be approximately circular, not necessarily geometrically standard circles.

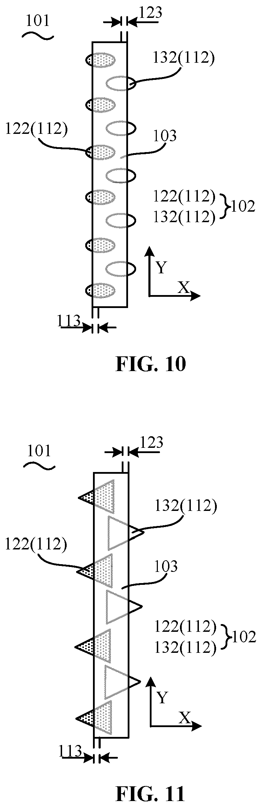

In some other embodiments, referring to FIG. 10, FIG. 10 is a schematic top view of a portion of a seventh grid line of the solar cell provided in some embodiments of the present disclosure, the orthographic projections of the plurality of contact portions 112 on the substrate 100 may have shapes of ellipses. It is noted that due to limitation in accuracy of the process for forming the plurality of contact portions 112, when the orthographic projections of the plurality of contact portions 112 on the substrate 100 have shapes of ellipses, the ellipses may also be approximately elliptical, not necessarily geometrically standard ellipses.

In some other embodiments, referring to FIG. 11, FIG. 11 is a schematic top view of a portion of an eighth grid line of the solar cell provided in some embodiments of the present disclosure, the orthographic projections of the plurality of contact portions 112 on the substrate 100 may have shapes of triangles.

It is noted that in practice, the orthographic projections of the plurality of contact portions 112 on the substrate 100 may also have shapes of trapezoids or N-sided polygons, where N is a positive integer greater than 4.

In some embodiments, referring to FIG. 9, the orthographic projections of the plurality of contact portions 112 on the substrate 100 may have shapes of circles or ellipses, and one respective first contact portion of the first contact portions 122 is tangential to a second contact portion of the second contact portions 132 adjacent to the respective first contact portion 122 in the second direction Y. In this way, although a first contact portion 122 and a second contact portion 132 adjacent to this first contact portion 122 are partially connected to each other, most of the surface areas of the first contact portion 122 and the second contact portion 132 are spaced apart in the second direction Y, which is conducive to reducing the amount of material required for the contact structure 102 as much as possible, with the dimension of the connection layer 103 remains unchanged.

It is noted that FIG. 9 shows an exemplary arrangement in which the orthographic projections of the plurality of contact portions 112 on the substrate 100 have shapes of circles, and a first contact portion 122 is tangential to a second contact portion 132 adjacent to this first contact portion 122 in the second direction Y. In practice, when the orthographic projections of the plurality of contact portions 112 on the substrate 100 have shapes of circles, the first contact portions 122 and the second contact portion 132 may space apart from each other in the second direction Y.

Moreover, when the orthographic projections of the plurality of contact portions 112 on the substrate 100 have shapes of ellipses, a first contact portion 122 may also be tangential to a second contact portion 132 adjacent to this first contact portion 122 in the second direction Y. FIG. 10 shows merely an exemplary arrangement in which the orthographic projections of the plurality of contact portions 112 on the substrate 100 have shapes of ellipses, and the first contact portions 122 and the second contact portion 132 space apart from each other in the second direction Y.

In some embodiments, referring to FIGS. 1 to 11, an orthographic projection of one respective contact portion of the plurality of contact portions 112 on the substrate 100 may have an area ranged from 100µm2 to 5000µm2, for example, may be 300µm2, 500µm2, 800µm2, 1000µm2, 1200µm2, 1500µm2, 1700µm2, 2000µm2, 2300µm2, 2500µm2, 2800µm2, 3000µm2, 3300µm2, 3500µm2, 3800µm2, 4000µm2, 4200µm2, 4500µm2, 4800 µm2, or the like.

It is noted that when an area of an orthographic projection of a contact portion 112 on the substrate 100 is less than 100µm2, a contact area between a single contact portion 112 and the connection layer 103 is too small, which is not conducive to improving the performance of electrical connections between the contact portions 112 and the substrate 100, nor is it conducive to improving the contact performance between the contact portions 112 and the connection layer 103. When an area of an orthographic projection of a contact portion 112 on the substrate 100 is greater than 5000µm2, the effect of reducing the amount of material required for the contact structure 102 solely relying on the spacing between adjacent contact portions 112 is limited. Thus, it is designed that an orthographic projection of one respective contact portion 112 on the substrate 100 has an area ranged from 100µm2 to 5000µm2, which is conducive to improving the performance of electrical connections between the contact portions 112 and the substrate 100, improving the contact performance between the contact portions 112 and the connection layer 103, and to reducing the amount of material required for the contact structure 102 as much as possible.

In some embodiments, referring to FIGS. 1 to 7 or FIGS. 9 to 11, the connection layer 103 may have a width ranged from 10µm to 70µm in the first direction X, for example, may be 15µm, 20µm, 25µm, 30µm, 35µm, 40µm, 45µm, 50µm, 55µm, 60µm, or 65µm.

In some embodiments, referring to FIG. 1, in the first direction X, a width of the connection layer 103 may be substantially equal to a width of the contact structure 102, different in that the first contact portions are unaligned with the second contact portions of the contact structure 102 in the first direction X, while the connection layer 103 is an elongated strip structure extending along the second direction Y.

In some embodiments, referring to FIG. 8, in the second direction Y, one respective first contact portion of the first contact portions 122 has a first edge 122a directly facing a second contact portion of the second contact portions 132 adjacent to the respective first contact portion 122, the second contact portion 132 has a second edge 132a directly facing the respective first contact portion 122, and a distance D between the first edge 122a and the second edge 132a is less than or equal to 200µm.

When the distance D between the first edge 122a and the second edge 132a is greater than 200µm, an arrangement distance between the respective first contact portion 122 and the second contact portion 132 is too large, resulting in excessively low arrangement density of the contact portions 112 of the contact structure 102, such that most of the connection layer 103 (referring to FIG. 1) are not electrically connected to the contact structure 102 (referring to FIG. 1). Thus, the distance D between the first edge 122a and the second edge 132a is set to be less than or equal to 200µm, which is conducive to ensuring a high arrangement density of the contact portions 112 of the contact structure 102, thereby ensuring as much as possible that most of the connection layer 103 can be electrically connected to the contact structure 102, and ensuring sufficient contact area between the connection layer 103 and the contact structure 102.

It is noted that in FIG. 8, the contact portions 112 of which orthographic projections on the substrate 100 have shapes of rectangles are taken as an example, and the distance D between the first edge 122a and the second edge 132a is denoted based on the exemplary contact portions 112. In practice, when the orthographic projections of the contact portions 112 on the substrate 100 have other shapes, the distance between the first edge and the second edge may also be less than or equal to 200µm.

In some embodiments, referring to FIGS. 1 to 11, in the thickness direction Z, the plurality of contact portions 112 may have thicknesses ranged from 1µm to 10µm, for example, 2µm, 3µm, 4µm, 5µm, 6µm, 7µm, 8µm, 9µm, or the like.

In some embodiments, referring to FIGS. 1 to 11, the connection layer 103 may have a thickness ranged from 4µm to 20µm, for example, 5µm, 6µm, 7µm, 8µm, 9µm, 10µm, 11µm, 12µm, 13µm, 14µm, 15µm, 16µm, 17µm, 18µm, 19µm, or the like.

The following provides a detailed illustration of the materials of the contact portions 112 and of the connection layer 103.

In some embodiments, referring to FIGS. 1 to 11, the material of the plurality of contact portions 112 may include silver particles, and the material of the connection layer 103 may include copper particles or silver-coated copper particles.

Considering a unit mass, the cost of silver particles is higher than that of copper particles and also higher than that of silver-coated copper particles. In addition, the performance of electrical connection between silver particles and the substrate 100 is higher than that between copper particles and the substrate 100, and also higher than that between silver-coated copper particles and the substrate 100. Thus, only the material of the contact structure of a grid line 101 is silver particles, which, on the one hand, is conducive to great reduction of the content of silver particles in the grid lines 101, and ensuring the performance of electrical connection between the grid lines 101 and the substrate 100 as much as possible, thereby ensuring that the solar cell has a high photoelectric conversion efficiency; on the other hand, compared to the amount of paste required for the contact structure 102, designing the connection layer 103 that requires a larger amount of paste to include copper particles or silver-coated copper particles can ensure sufficient amount of paste for the connection layer 103, such that the connection layer 103 can effectively collect carriers from the plurality of contact portions 112 of the contact structure 102, and the manufacturing cost of the connection layer 103 can be reduced.

In some embodiments, compared with simply using silver paste to form the grid lines on the first or second surface, the material of only the contact portions 112 of the grid lines 101 includes silver particles, that is, only the contact portions 112 are formed using silver paste. In this way, the amount of silver paste required to form the contact portions 112 can be lower, for example, reduced to 3mg to 15mg. When simply using silver paste to form the grid lines on the first or second surface, the amount of silver paste used for a single surface of the solar cell is up to 40mg. For the grid lines 101 in some embodiment of the present disclosure, the amount of silver paste used for a single surface of the solar cell may be reduced to 3mg to 15mg.

It is noted that for the grid lines 101 in some embodiment of the present disclosure, in addition to the arrangement in which the first contact portions are unaligned with the second contact portions of the contact structure 102 in the first direction X to reduce the amount of silver paste required to form the contact portions 112, the amount of silver paste required to form the contact portions 112 can be further reduced by reducing the thicknesses of the contact portions 112 in the thickness direction Z.

In some embodiments, referring to FIGS. 1 to 11, the material of the connection layer 103 may include copper particles, and the copper particles may have diameters ranged from 50nm to 1500nm, for example, may be 100nm, 200nm, 300nm, 400nm, 500nm, 600nm, 700nm, 800nm, 900nm, 1000nm, 1100nm, 1200nm, 1300nm, 1400nm, or the like.

In some other embodiments, referring to FIGS. 1 to 11, the material of the connection layer 103 may include silver-coated copper particles, and the silver-coated copper particles may have diameters ranged from 1µm to 10µm, for example, may be 2µm, 3µm, 4µm, 5µm, 6µm, 7µm, 8µm, 9µm, or the like.

It is noted that the diameters of the silver-coated copper particles refer to the outer diameters of the silver-coated copper particles, i.e. the diameters of the outer contours of the silver-coated copper particles.

In some embodiments, a proportion of silver in the silver-coated copper particles ranges from 15% to 50%, for example, may be 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, or the like.

The following provides a detailed illustration of the types of the grid lines 101.

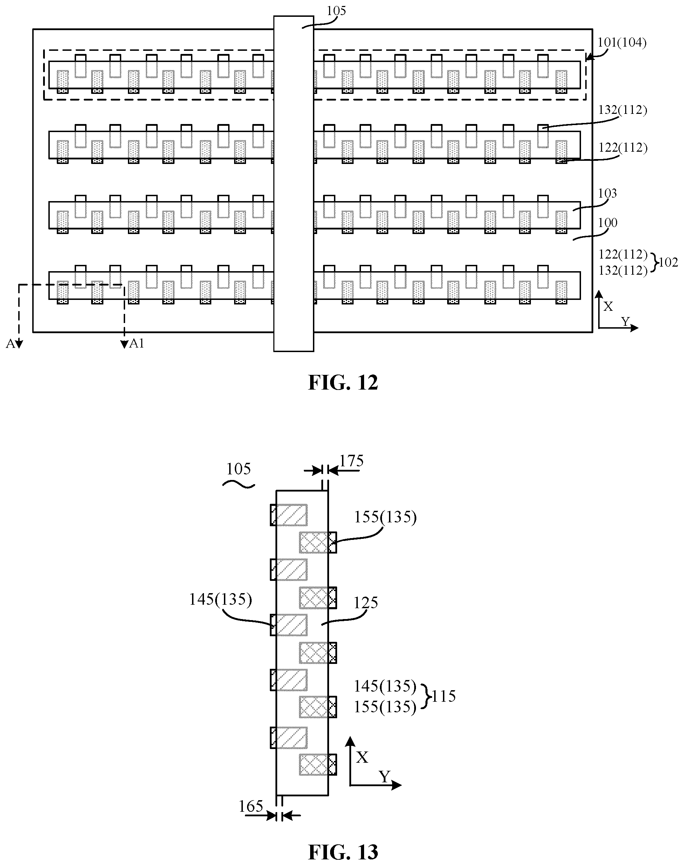

In some embodiments, referring to FIG. 12, FIG. 12 is a schematic top view of a portion of another solar cell provided in some embodiments of the present disclosure. The grid lines 101 are finger electrodes 104, and the busbars 105 are in a form of elongated strip structures extending along the first direction X; or the grid lines are busbars 105, and the finger electrodes 104 are in a form of elongated strip structures extending along the first direction X. It is noted that FIG. 12 exemplarily shows that the grid lines 101 are finger electrodes 104, and the busbars 105 are in the form of elongated strip structures extending along the first direction X. In practice, the grid lines also may be busbars, and the finger electrodes are in a form of elongated strip structures extending along the first direction.

It is noted that the designs of the grid lines 101 illustrated above are, no matter the grid lines 101 are finger electrodes 104 or busbars 105, conducive to improving the performance of electrical connection between the grid lines 101 and the substrate 100 and reducing the manufacturing cost of the grid lines 101. Moreover, the arrangement of the grid lines 101 in which the first contact portions are unaligned with the second contact portions is conducive to reducing the manufacturing difficulty of the grid lines 101.

Moreover, on the substrate 100, the arrangement density of the finger electrodes 104 is higher than that of the busbars 105. Therefore, compared to the total amount of material required to manufacture the busbars 105 on a single surface, the total amount of material required to manufacture the finger electrodes 104 on a single surface is generally higher. Thus, compared to the busbars 105, applying the designs of the grid lines 101 illustrated above to the finger electrodes 104 is more conducive to reducing the total amount of material required for manufacturing the grid lines 101, thereby reducing the manufacturing cost of the solar cell.

In addition, in some cases, electrical connection between the finger electrodes 104 and the substrate 100 is needed, and the busbars 105 may only be electrically connected to the finger electrodes 104 without being electrically connected to the substrate 100. The carriers in the substrate 100 may be first collected by the finger electrodes 104, and then collected by the busbars 105 electrically connected to the finger electrodes 104. In this way, it is not necessary to form direct electrical connection between the busbars 105 and the substrate 100. For example, the material used to form the busbars 105 does not need to be embedded in a passivation layer on the substrate 100. Therefore, the busbars 105 may be formed using a material having lower cost, as long as the electrical connection between the busbars 105 and the finger electrodes 104 can be achieved. On this basis, applying the designs of the grid lines 101 illustrated above to the finger electrodes 104 is not only conducive to improving the performance of electrical contact between the finger electrodes 104 and the substrate 100 with the aid of the contact structure 102, but also to reducing the manufacturing cost of the finger electrodes 104 with the aid of the connection layer 103. Moreover, the busbars 105 may be formed using a material having lower cost to further reduce the manufacturing cost of the solar cell.

It is noted that each of FIGS. 1 to 12 exemplarily shows that in the second direction Y, there is only one first contact portion 122 between two adjacent second contact portions 132. In other words, in the examples shown in FIGS. 1 to 12, for the plurality of contact portions 112 electrically connected to a same connection layer 103, in the second direction Y, there is only one second contact portion 132 between two adjacent first contact portions 122.

In practice, there is no limit to the number of the second contact portions arranged between two adjacent first contact portions, for example, there may be 2 or 3 second contact portions. Similarly, there is no limit to the number of the first contact portions arranged between two adjacent second contact portions, for example, there may be 2 or 3 first contact portions. In other words, in practice, in the second direction, there may be no second contact portion between two adjacent first contact portions, or there may be no first contact portion between two adjacent second contact portions. For example, one first contact portion and three second contact portions are arranged as a set, and a plurality of sets are repeatedly arranged along the second direction.

In some other embodiments, referring to FIGS. 1 and 13, FIG. 13 is a schematic top view of a portion of a busbar of the solar cell provided in some embodiments of the present disclosure. The grid lines 101 are finger electrodes, and the solar cell may further include: busbars 105 arranged at intervals on at least one of the first surface 110 (referring to FIG. 3) and the second surface 120 (referring to FIG. 3) along the second direction Y. Each busbar of at least some of the busbars 105 includes a respective connection structure 115 and a respective interconnection layer 125 that are electrically connected to the substrate 100, the respective connection structure 115 includes a plurality of connection portions 135 arranged along the first direction X, and the respective interconnection layer 125 is an elongated strip structure extending along the first direction X. The respective interconnection layer 125 is electrically connected to the plurality of connection portions 135, the plurality of connection portions 135 include first connection portions 145 and second connection portions 155 alternately arranged along the second direction Y, and the respective interconnection layer 125 includes a third side portion 165 and a fourth side portion 175 extending along the second direction Y. The first connection portions 145 are electrically connected to at least the third side portion 165, the second connection portions 155 are electrically connected to at least the fourth side portion 175, and a material of the plurality of connection portions 135 is different from a material of the respective interconnection layer 125.

It is noted that in addition to the contact structures 102 configured for the electrical connection between the finger electrodes and the substrate 100, the busbars 105 also include connection structures 115 configured for the electrical connection between the busbars and the substrate 100. In other words, in addition to some portions of the finger electrodes directly electrically connected to the substrate 100, the busbars 105 also include some portions that are directly electrically connected to the substrate 100. Therefore, the carriers in the substrate 100 may not only be collected via the finger electrodes and then by the busbars 105, but may also be directly collected by the busbars 105 through the connection structures 115, which is conducive to shortening the transfer distances of some carriers in the substrate 100 to the busbars 105, thereby reducing the transfer loss of carriers and improving the collection efficiency of carriers by the busbars 105. In this way, the photoelectric conversion efficiency of solar cells can be improved.

It is noted that the connection structures 115 of the busbars 105 are similar to the contact structures 102 of the finger electrodes, the connection portions 135 of the connection structures 115 are similar to the contact portions 112 of the contact structure 102, the first connection portions 145 are similar to the first contact portions 122, the second connection portions 155 are similar to the second contact portions 132, the interconnection layer 125 is similar to the connection layer 103, the third side portion 165 is similar to the first side portion 113, and the fourth side portion 175 is similar to the second side portion 123, different in that the dimensions of the connection portions 135 are different from those of the contact portions 112, and the dimension of the interconnection layer 125 is different from that of the connection layer 103. Therefore, the connection structures 115 and the interconnection layers 125 of the busbars 105 will not be discussed in detail here. In addition, FIG. 13 only shows an exemplary arrangement of the busbars 105 in which the connection structure 115 is electrically connected to the interconnection layer 125. Other arrangements of the connection between the connection structure 115 and the interconnection layer 125 may refer to the above-mentioned arrangements of the connection between the contact structure and the connection layer.

The following provides a detailed illustration of the types of the solar cell.

In some embodiments, the solar cell includes grid lines formed on both surfaces. The solar cell may be a PERC cell, a TOPCON solar cell, a HIT/HJT (heterojunction technology) solar cell, a solar thin-film cell, or any combination thereof. The solar thin-film cells include but are not limited to perovskite solar thin-film cells, copper-indium-selenide solar thin-film cells, gallium arsenide solar thin-film cells, and cadmium sulfide solar thin-film cells.

On this basis, referring to FIG. 3, the first surface 110 of the substrate 100 may be the front surface. On the first surface 110, a plurality of front finger electrodes (not shown) are provided at intervals along the first direction X, and a plurality of front busbars (not shown) are provided at intervals along the second direction Y. The second surface 120 of the substrate 100 may be the back surface. On the second surface 120, a plurality of back finger electrodes are provided at intervals along the first direction X, and a plurality of back busbars (not shown) are provided at intervals along the second direction Y.

It is noted that the solar cells may be single-sided cells, where the first surface 110 may serve as a light-receiving surface for receiving incident light, and the second surface 120 may serve as a back surface. Alternatively, the solar cells may be double-sided cells, and both the first surface 110 and the second surface 120 may serve as light-receiving surfaces for receiving incident light. It shall be understood that the back surface herein may also receive incident light, but the degree of reception of incident light is weaker than that of the light-receiving surface, and is therefore regarded as a back surface.

In some embodiments, referring to FIG. 3, the back finger electrodes may be implemented as the grid lines 101 illustrated in above embodiments, and each of the back busbars, front finger electrodes, and front busbars may be implemented as a single-layered and elongated strip structure. In this way, the manufacturing cost of the solar cells can be reduced by forming the grid lines 101 on the second surface 120, and excessive obstruction of the substrate 100 by the front busbars formed on the first surface and the back busbars can be prevented, to ensure that the solar cell has a sufficient light-receiving surface.

In some other embodiments, the back finger electrodes and the front finger electrodes may be implemented as the grid lines 101 (referring to FIGS. 1 to 11) illustrated in above embodiments. Each of the back busbars and the front busbars may be implemented as a single-layered and elongated strip structure, or the back busbars and the front busbars may be implemented as the busbars 105 (referring to FIG. 13) illustrated in above embodiments.

In some other embodiments, the back finger electrodes may be implemented as the grid lines 101 (referring to FIGS. 1 to 11) illustrated in above embodiments, the back busbars may be implemented as the busbars 105 (referring to FIG. 13) illustrated in above embodiments, and each of the front finger electrodes and the front busbars may be implemented as a single-layered and elongated strip structure.

In some other embodiments, the front finger electrodes may be implemented as the grid lines 101 (referring to FIGS. 1 to 11) illustrated in above embodiments, the front busbars may be implemented as the busbars 105 (referring to FIG. 13) illustrated in above embodiments, and each of the back finger electrodes and the back busbars may be implemented as a single-layered and elongated strip structure.

In some embodiments, the solar cell is a back contact solar cell, also known as BC solar cell. The BC solar cells include but are not limited to interdigited back contact (IBC) solar cells, heterojunction back contact (HBC) solar cells, TOPCon back contact (TBC) solar cells, or hybrid passivated back contact (HPBC) solar cells. Thus, referring to FIG. 3, the first surface 110 or the second surface 120 may be considered as the back surface of the finally formed solar cell.

On this basis, the back finger electrodes and the back busbars are provided on the back surface of the solar cell.

In some embodiments, the back finger electrodes provided on the first surface or the second surface may be implemented as the grid lines 101 (referring to FIGS. 1 to 11) illustrated in above embodiments, and each of the back busbars may be implemented as a single-layered and elongated strip structure.

In some other embodiments, the back finger electrodes provided on the first surface or the second surface may be implemented as the grid lines 101 (referring to FIGS. 1 to 11) illustrated in above embodiments, and each of the back busbars provided on the first surface or the second surface may be implemented as the busbars 105 (referring to FIG. 13) illustrated in above embodiments.

In the contact structure 102 of the solar cell, one respective first contact portion of the first contact portions 122 is unaligned, in the first direction X, with a second contact portion 132 adjacent to the respective first contact portion 122 in the second direction Y. Thus, on the one hand, with the dimension of the respective connection layer 103 being unchanged, the arrangement in which the first contact portions 122 are unaligned with the second contact portions 132 is conducive to reduction of materials consumption of the contact structure 102 while ensuring sufficient contact areas between the contact structure 102 and the connection layer 103, compared with manufacturing the contact structure to have an elongated strip structure similar to the connection layer 103, which is conducive to improving the performance of electrical connection between the grid lines 101 and the substrate 100, and to reducing the manufacturing cost of the grid lines 101. On the other hand, in the first direction X, each first contact portion 122 has a respective third edge away from the second contact portions 132, and each second contact portion 132 has a respective fourth edge away from the first contact portions 122, the arrangement in which the first contact portions 122 are unaligned with the second contact portions 132 is conducive to increasing a maximum distance between the respective third edge and the respective fourth edge in the first direction X, which, with the dimension of the respective connection layer 103 being unchanged, is conducive to reducing the requirement for alignment accuracy between the contact structure 102 and the connection layer 103, compared with manufacturing the contact structure to have an elongated strip structure similar to the connection layer 103. In other words, the arrangement in which the first contact portions 122 are unaligned with the second contact portions 132 allows for a larger offset error between the contact structure 102 and the connection layer 103 in the first direction X, and as long as an error is not larger than this offset error, the contact area between the connection layer 103 and the contact structure 102 is unchanged. In this way, the difficulty of manufacturing the connection layer 103 and therefore the difficulty of manufacturing the grid lines 101 can be reduced, while the good performance of the electrical contact between the contact structure 102 and the connection layer 103 can be ensured.

Some embodiments of the present disclosure provide a method for manufacturing the solar cells provided in the above embodiments. In the following, a detailed illustration of the method for manufacturing solar cells will be provided, in conjunction with the accompanying drawings. It is noted that the parts same as or corresponding to those in the above embodiments will not be repeated here.

Referring to FIGS. 1 to 11, the method for manufacturing solar cells includes: providing a substrate 100 including a first surface 110 and a second surface 120, where the first surface 110 and the second surface 120 are opposite to each other and each substantially perpendicular to a thickness direction Z of the substrate 100; and forming grid lines 101 arranged at intervals on at least one of the first surface 110 and the second surface 120 along a first direction X. Each grid line of at least some of the grid lines 101 includes a respective contact structure 102 and a respective connection layer 103 that are electrically connected to the substrate 100, the respective contact structure 102 includes a plurality of contact portions 112 arranged along a second direction Y, the respective connection layer 103 is an elongated strip structure extending along the second direction Y, and the first direction X intersects with the second direction Y. The respective connection layer 103 is electrically connected to the plurality of contact portions 112. The plurality of contact portions 112 include first contact portions 122 and second contact portions 132 alternately arranged along the second direction Y, and the respective connection layer 103 includes a first side portion 113 and a second side portion 123 extending along the second direction Y. The first contact portions 122 are electrically connected to at least the first side portion 113, the second contact portions 132 are electrically connected to at least the second side portion 123, and a material of the plurality of contact portions 112 is different from a material of the respective connection layer 103.

In some embodiments, referring to FIG. 1, FIG. 4, FIG. 5, or FIG. 6, the first contact portions 122 are electrically connected to at least the first side portion 113, and the second contact portions 132 are electrically connected to at least the second side portion 123, such that one respective first contact portion of the first contact portions 122 is unaligned, in the first direction X, with a second contact portion 132 adjacent to the respective first contact portion 122 in the second direction Y. Herein, the first contact portions 122 are electrically connected to at least the first side portion 113 and the second contact portions 132 are electrically connected to the second side portion 123, or the second contact portions 132 are electrically connected to at least the second side portion 123 and the first contact portions 122 are electrically connected to the first side portion 113.

In some other embodiments, referring to FIG. 7, the first contact portions 122 are electrically connected to at least the first side portion 113, the second contact portions 132 are electrically connected at least to the second side portion 123, and the first contact portions 122 and the second contact portions 132 are arranged to space apart from each other along the second direction Y. Specifically, each first contact portion 122 is electrically connected to both the first side portion 113 and the second side portion 123, and each second contact portion 132 is electrically connected to both the first side portion 113 and the second side portion 123.

It is noted that dividing the contact portions 112 of the contact structure 102 into the first contact portions 122 electrically connected to at least the first side portion 113 and the second contact portions 132 electrically connected at least to the second side portion 123 is conducive to reducing the amount of material required for the contact structure 102 by adjusting the positional relationship between the connection layer 103 and the first contact portions 122 and the second contact portions 132, while ensuring that there are sufficient contact areas between the contact structure 102 and the connection layer 103. In this way, the performance of electrical connection between the grid lines 101 and the substrate 100 can be improved, and the manufacturing cost of the grid lines 101 can be reduced.

In the following, a detailed illustration of the manufacturing process of the grid lines 101 will be provided.

In some embodiments, referring to FIGS. 2 and 3, the grid lines 101 may be finger electrodes, and the second surface 120 includes first printing areas (not shown) and second printing areas (not shown) that partially overlap with the first printing areas. It is noted that the first printing areas correspond to the subsequently formed contact structure 102, and the second printing areas correspond to the subsequently formed connection layer 103. In other words, the first printing areas are substantially overlapped with the orthographic projection of the subsequently formed contact structure 102 on the substrate 100, and the second printing areas are substantially overlapped with the orthographic projection of the subsequently formed connection layer 103 on the substrate 100.

Referring to FIGS. 2 and 3, the operation of forming the grid lines may include: printing first paste on the first printing areas using a first screen printing process, performing sintering on the first paste to form the respective contact structure 102 on the first printing areas, printing second paste on the second printing areas using a second screen printing process, and curing the second paste to form the respective connection layer 103 on the second printing areas. The first paste is firing-through paste, the second paste is non-firing paste, and a process temperature for performing the sintering is greater than a process temperature for curing.

Due to the fact that the first paste is firing-through paste and the second paste is non-firing paste, the finally formed contact structure 102 is electrically connected to the substrate 100, for example is embedded in a passivation layer on the substrate 100. However, the connection layer 103 is formed over the surface of the substrate 100, that is, is not embedded in the passivation layer on the substrate 100, nor in direct electrical connection to the substrate 100.

In some embodiments, the first paste may be silver paste, and the second paste may be copper paste or silver-coated copper paste. In practice, due to the arrangement of the contact structure 102 in which the first contact portions 122 and the second contact portions 132 are alternately arranged, the amount of the first paste consumed for a single surface can be reduced to 3mg to 15mg, for example, may be 4mg, 5mg, 6mg, 7mg, 8mg, 9mg, 10mg, 11mg, 12mg, 13mg, 14mg, or the like.

In some embodiments, a solid content in the silver paste may range from 75% to 92%, for example, may be 76%, 77%, 78%, 79%, 80%, 81%, 82%, 83%, 84%, 85%, 86%, 87%, 88%, 89%, 90%, 91%, or the like.

It is noted that the solids in the silver paste include not only silver particles but also at least glass particles. The solid content in the silver paste refers to the total content of all solids, including silver particles, in the silver paste.

In some situations, in the process of printing the grid lines all using silver paste, the solid content in the silver paste is generally high, such as greater than 90%. Compared to the process of printing the grid lines all using silver paste, the solid content of the silver paste used in the method for manufacturing solar cells provided in some other embodiments of the present disclosure may be lower, thus the silver paste used to form the contact structure 102 is thinner. In other words, the viscosity of the silver paste used to form the contact structure 102 is lower. In this way, when the silver paste is printed on the first printing areas of the substrate 100, the silver paste may spread on the substrate 100 to a certain degree, which is conducive to increasing the contact area between the subsequently formed contact structure 102 using the silver paste and the substrate 100.

It is noted that the second surface 120 may be considered as the back surface of the solar cell. By combining the first screen printing process and the second screen printing process, a grid line 101 including the contact structure 102 and the connection layer 103 can be formed on the second surface 120. In addition, taking the formation of the grid lines 101 on the second surface 120 as an example, in practice, the first screen printing process and the second screen printing process may also be applied on the first surface to form the grid lines, which will not be repeated here. Moreover, taking the grid lines 101 formed on the second surface 120 being finger electrodes as an example, in practice, the grid lines formed using the first screen printing process and the second screen printing process may also be busbars formed on the first surface or the second surface, which will not be repeated here.

Referring to FIG. 13, when the busbars 105 include the connection structure 115 and the interconnection layer 125 that are electrically connected to the substrate 100 (referring to FIG. 2), the formation process of the connection structure 115 is similar to that of the contact structure 102 (referring to FIGS. 1 to 11), and the formation process of the interconnection layer 125 is similar to that of the connection layer 103 (referring to FIGS. 1 to 11), which will not be repeated here.

In the following, a detailed illustration of the manufacturing process of the busbars 105, excluding the grid lines 101, formed on the second surface 120 will be provided.

In some embodiments, referring to FIG. 2, the second surface 120 further includes third printing areas (not shown). The method further includes: printing the first paste on the third printing areas using the first screen printing process, and performing the sintering on the first paste to form busbars on the third printing areas. It is noted that the third printing areas correspond to the subsequently formed busbars. In other words, the third printing areas are substantially overlapped with the orthographic projection of the subsequently formed busbars on the substrate 100.

It is noted that manufacturing of the contact structures 102 of the grid lines 101 and manufacturing of the busbars may be performed in a same operation, which is conducive to reducing one printing process and further reducing the manufacturing cost of solar cells.

In some other embodiments, referring to FIG. 2, the second surface 120 further includes third printing areas (not shown). The method further includes: printing the second paste on the third printing areas using the second screen printing process, and curing the second paste to form the busbars 105 (referring to FIG. 12) on the third printing areas. It is noted that the third printing areas correspond to the subsequently formed busbars 105. In other words, the third printing areas are substantially overlapped with the orthographic projection of the subsequently formed busbars 105 on the substrate 100.

It is noted that manufacturing of the connection layers 103 of the grid lines 101 and manufacturing of the busbars 105 may be performed in a same operation, which is also conducive to reducing one printing process and further reducing the manufacturing cost of solar cells.

In some other embodiments, the first screen printing process and the sintering process are used to form only the contact structures of the grid lines, and the second screen printing process and the curing process are used to form only the connection layers of the grid lines. Subsequently, the busbars on the second surface are formed using other processes.

In some embodiments, referring to FIGS. 3 and 12, the finger electrodes 104 formed on the second surface 120 may be back finger electrodes, the busbars 105 formed on the second surface 120 are back busbars, and the first surface 110 includes fourth printing areas (not shown) extending along the first direction X and fifth printing areas (not shown) extending along the second direction Y. It is noted that the fourth printing areas correspond to the subsequently formed front finger electrodes, and the fifth printing areas correspond to the subsequently formed front busbars. In other words, the fourth printing areas are substantially overlapped with the orthographic projection of the subsequently formed front finger electrodes on the substrate 100, and the fifth printing areas are substantially overlapped with the orthographic projection of the subsequently formed front busbars on the substrate 100.

Before performing the sintering, the method may further include: printing third paste on the fourth printing areas using a third screen printing process; and printing fourth paste on the fifth printing areas using a fourth screen printing process. Performing the sintering may include: performing the sintering on the third paste to form front finger electrodes on the fourth printing areas; and performing the sintering on the fourth paste to form front busbars on the fifth printing areas.

In some embodiments, the third paste and the fourth paste may be the same, that is, the material of the front finger electrodes and the material of the front busbars may be the same.

It is noted that the sequence of the third screen printing process and the fourth screen printing process may be reversed.

Based on the above, it is known that when the grid lines 101 are back finger electrodes, the printing process of the solar cell at least includes the following situations: in some situations, the back busbars, the contact structures 102 of the grid lines 101, the front busbars, and the front finger electrodes may be formed using four printing processes, and then are sintered together, and finally the printing process and curing treatment of the connection layers 103 of the grid lines 101 may be carried out. In some other situations, the back busbars and the contact structures 102 of the grid lines 101 are formed using a same printing process, the front busbars and the front finger electrodes may be formed using two printing processes, respectively, followed by being sintered together, and finally the printing process and curing treatment of the connection layers 103 of the grid lines 101 are carried out. In some other situations, the contact structures 102 of the grid lines 101, the front busbars, and the front finger electrodes may be formed using three printing processes, respectively, followed by being sintered together, then the connection layers 103 of the grid lines 101 and the back busbars may be formed using a same printing process, and finally cured treatment is carried out.

Some embodiments of the present disclosure provide a tandem solar cell, including the solar cell as illustrated in the above embodiments or the solar cell formed using the method for manufacturing solar cells as illustrated in the above embodiments. In the following, a detailed illustration of the tandem solar cell will be provided in conjunction with the accompanying drawings. It is noted that the parts same as or corresponding to those in the above embodiments will not be repeated here.

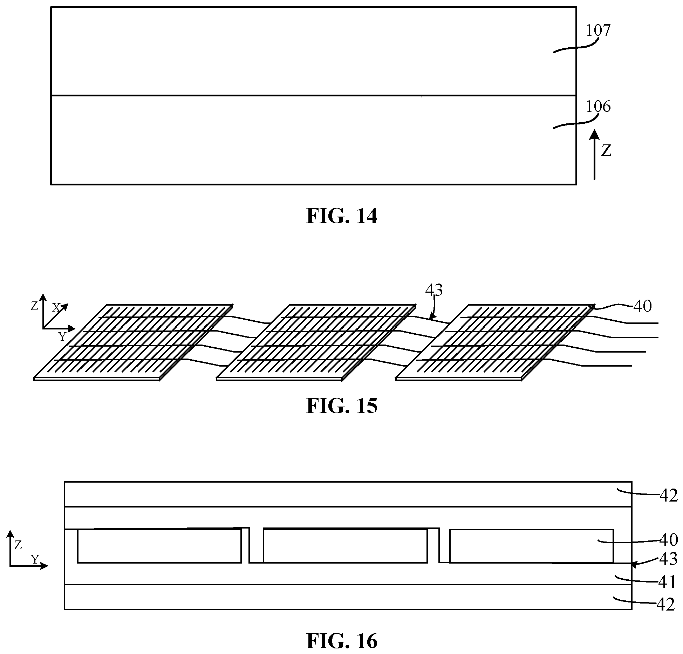

Referring to FIG. 14, FIG. 14 is a schematic cross-sectional view of a portion of a tandem solar cell provided in some embodiments of the present disclosure. The tandem solar cell includes: a bottom solar cell 106 and a top solar cell 107 arranged on a side of the bottom solar cell 106. The bottom solar cell 106 includes the solar cell as illustrated in the above embodiments, or the bottom solar cell 106 is manufactured using the method as illustrated in the above embodiments.

In some embodiments, the top solar cell 107 may be one of perovskite solar cells, donor-acceptor solar cells, cadmium telluride (CdTe) solar cells, copper indium gallium diselenide (CIGS) solar cells, or gallium arsenide (GaAs) solar cells.

In some embodiments, the top solar cell 107 may include: a first transfer layer, a perovskite substrate, a second transfer layer, a transparent conductive layer, and an anti-reflection layer that are stacked. The first transfer layer is directly facing the bottom solar cell 106.

In some embodiments, the first transfer layer may be one of an electron transfer layer and a hole transfer layer, and the second transfer layer may be the other one of the electron transfer layer and the hole transfer layer.

In some embodiments, the top solar cell 107 has a bandgap width wider than that of the bottom solar cell 106. Therefore, stacking the top solar cell 107 on the bottom solar cell 106 can enable the tandem solar cell to have a wider spectral response range, thereby maximizing the utilization of solar energy and improving the efficiency of the solar cell.

In some embodiments, a back contact tandem solar cell may further include an intermediate connection layer (not shown), which is arranged between and electrically connected to the bottom solar cell 106 and the top solar cell 107.

In some embodiments, the intermediate connection layer is generally a tunnel junction or a very thin metal or transparent electrode recombination layer. In some embodiments, the intermediate connection layer may be a transparent conductive oxide, which has good optoelectronic properties, high photon transmittance, and high conductivity, thereby maintaining good ohmic contact between the top solar cell 107 and the bottom solar cell 106.

In some other embodiments, the back finger electrodes, back busbars, front finger electrodes, and front busbars of the solar cell serving as the bottom solar cell 106 may also be used as the intermediate connection layers for the electrical connection with the top solar cell 107.

Some embodiments of the present disclosure provide a photovoltaic module. The photovoltaic module includes a plurality of solar cells as illustrated in the above embodiments, or includes a plurality of solar cells formed using the method for manufacturing solar cells as illustrated in the above embodiments, or is formed by connecting a plurality of tandem solar cells as illustrated in the above embodiments. The photovoltaic module is configured to convert received light energy into electrical energy. It is noted that reference may be made to the corresponding illustration in the above embodiments for the parts same as or corresponding to those in the above embodiments, which will not be repeated here.

Referring to FIG. 15, FIG. 16, and FIGS. 1 to 13, the photovoltaic module includes: at least one solar cell string, at least one packaging adhesive film 41 configured to cover a surface of the at least one solar cell string, and at least one cover plate 42 configured to cover a surface of the at least one packaging adhesive film 41 away from the at least one solar cell string. The at least one solar cell string is formed by electrically connecting a plurality of solar cells 40 as illustrated in the above embodiments, or by electrically connecting a plurality of solar cells 40 formed using the method for manufacturing solar cells as illustrated in the above embodiments, or by electrically connecting a plurality of tandem solar cells as illustrated in the above embodiments.

FIG. 15 is a schematic perspective view of a portion of a cell string of a photovoltaic module provided in some embodiments of the present disclosure, and FIG. 16 is a schematic cross-sectional view of a portion of the photovoltaic module provided in some embodiments of the present disclosure.

In some embodiments, solar cells 40 each in a form of a whole or segments are electrically connected to form a plurality of solar cell strings, and the plurality of solar cell strings are electrically connected in series and/or in parallel. Each solar cell 40 may be a whole cell or a segmented cell, where a segmented cell refers to a cell formed by cutting a whole cell.

In some embodiments, referring to FIGS. 15 and 16, the plurality of solar cells 40 may be electrically connected using conductive strips 43. FIGS. 15 and 16 only schematically show a positional relationship between solar cells 40, that is, the grid lines of solar cells 40 with the same polarity are arranged in a same direction, in other words, the grid lines of each solar cell 40 with positive polarity are arranged to direct a same side, so that a conductive strip 43 connects on different sides of two adjacent solar cells 40. In some other embodiments, the electrodes of each solar cell with different polarities may be arranged to direct a same side, that is, the electrodes of adjacent solar cells are arranged in an order of first polarity, second polarity, first polarity, and so on, and a conductive strip connects on a same side of two adjacent solar cells.

In some embodiments, the at least one packaging adhesive film 41 includes a first packaging layer and a second packaging layer. The first packaging layer covers one of the front surface and the back surface of the solar cell 40, and the second packaging layer covers the other one of the front surface and the back surface of the solar cell 40. At least one of the first packaging layer and the second packaging layer may be an organic packaging adhesive film such as a polyvinyl butyral (PVB) adhesive film, an ethylene-vinyl acetate copolymer (EVA) adhesive film, a polyethylene-octene elastomer (POE) adhesive film, or a polyethylene terephthalate (PET) adhesive film. Alternatively, at least one of the first packaging layer and the second packaging layer may also be an EP adhesive film, an EPE adhesive film, or a PVP adhesive film. The EP adhesive film refers to a co-extruded adhesive film composed of stacked EVA adhesive film and POE adhesive film. The EPE adhesive film refers to a co-extruded adhesive film formed by sequentially stacked EVA adhesive film, POE adhesive film, and EVA adhesive film. The PVP adhesive film refers to a co-extruded adhesive film formed by stacked POE adhesive film, EVA adhesive film, and POE adhesive film. The method of producing co-extruded adhesive films may include during producing the adhesive films, sequentially extruding one or more raw materials onto another type of adhesive film that has been made, or bonding different types of adhesive films that have been made together.

In some cases, there is a boundary between the first packaging layer and the second packaging layer before lamination. After lamination, the formed photovoltaic module no longer includes the first packaging layer and the second packaging layer, that is, the first packaging layer and the second packaging layer have formed an integrated packaging adhesive film 41.

In some embodiments, the cover plate 42 may be a transparent cover plate such as a glass cover plate or a plastic cover plate. The surface of the cover plate 42 facing the packaging adhesive film 41 may be an uneven surface or a textured surface including a plurality of protruding structures, thereby increasing the utilization rate of incident light. The at least one cover plate 42 includes a first cover plate and a second cover plate. The first cover plate is opposite to the first packaging layer, and the second cover plate is opposite to the second packaging layer.

Those skilled in the art shall understand that the above-mentioned embodiments are specific examples for implementing the present disclosure. In practice, various changes may be made in form and details without departing from the scope of the present disclosure. Therefore, the patent scope of protection of the present disclosure shall be subject to the scope limited by the appended claims.

## Claims

1. A solar cell, comprising:
a substrate (100) including a first surface (110) and a second surface (120) opposite to each other and each substantially perpendicular to a thickness direction (Z) of the substrate (100); and
grid lines (101) arranged at intervals on at least one of the first surface (110) and the second surface (120) along a first direction (X), wherein each grid line (101) of at least some of the grid lines (101) includes a respective contact structure (102) and a respective connection layer (103) that are electrically connected to the substrate (100), the respective contact structure (102) includes a plurality of contact portions (112) arranged at intervals along a second direction (Y), the respective connection layer (103) is an elongated strip structure extending along the second direction (Y), and the first direction (X) intersects with the second direction (Y);
wherein the respective connection layer (103) is electrically connected to the plurality of contact portions (112) and includes a material that is different from a material of the plurality of contact portions (112), and an orthographic projection of the respective connection layer (103) on the substrate (100) partially overlaps with orthographic projections of the plurality of contact portions (112) on the substrate (100);
wherein the plurality of contact portions (112) include first contact portions (122) and second contact portions (132) alternately arranged along the second direction (Y), and the respective connection layer (103) has a first side extending along the second direction (Y), an opposing second side extending along the second direction (Y), a first side portion (113) extending along the second direction (Y) on the first side, and a second side portion (123) extending along the second direction (Y) on the second side; and
wherein the first contact portions (122) traverses at least the first side portion (113), and the second contact portions (132) traverses at least the second side portion (123).

2. The solar cell according to claim 1, wherein in the second direction (Y), the first contact portions (122) are unaligned with the second contact portions (132).

3. The solar cell according to claim 1, wherein in the second direction (Y), segments of the first contact portions (122) are aligned with segments of the second contact portions (132).

4. The solar cell according to claim 3, wherein one respective first contact portion of the first contact portions (122) includes a first segment (1221) and a second segment (1222), the first segment (1221) is aligned with the segments of the second contact portions (132) in the second direction (Y), and the second segment (1222) has a width less than or equal to 25 µm in the first direction (X).

5. The solar cell according to any one of claims 1 to 4, wherein the orthographic projections of the plurality of contact portions (112) on the substrate (100) have shapes of circles, ellipses, triangles, rectangles, trapezoids, or N-sided polygons, wherein N is a positive integer greater than 4.

6. The solar cell according to any one of claims 1 to 5, including finger electrodes (104) and busbars (105), wherein:
the grid lines (101) are finger electrodes (104), and the busbars (105) are in a form of elongated strip structures extending along the first direction (X); or
the grid lines (101) are busbars (105), and the finger electrodes (104) are in a form of elongated strip structures extending along the first direction (X).

7. The solar cell according to any one of claims 1 to 5, wherein the grid lines (101) are finger electrodes (104), and the solar cell further includes:
busbars (105) arranged at intervals on at least one of the first surface (110) and the second surface (120) along the second direction (Y), wherein each busbar of at least some of the busbars (105) includes a respective connection structure (115) and a respective interconnection layer (125) that are in electrical connection to the substrate (100), the respective connection structure (115) includes a plurality of connection portions (135) arranged at intervals along the first direction (X), and the respective interconnection layer (125) is an elongated strip structure extending along the first direction (X);
wherein the respective interconnection layer (125) is in electrical connection to the plurality of connection portions (135), the plurality of connection portions (135) include first connection portions (145) and second connection portions (155) alternately arranged along the second direction (Y), and the respective interconnection layer (125) has a third side extending along the second direction, an opposing fourth side extending in the second direction, a third side portion (165) extending along the second direction (Y) on the third side, and a fourth side portion (175) extending along the second direction (Y) on the fourth side; and
wherein the first connection portions (145) traverse at least the third side portion (165), the second connection portions (155) traverse at least the fourth side portion (175), and a material of the plurality of connection portions (135) is different from a material of the respective interconnection layer (125).

8. The solar cell according to any one of claims 1 to 7, wherein the plurality of contact portions (112) includes silver particles, and the respective connection layer (103) includes copper particles or silver-coated copper particles; and
wherein the copper particles have diameters ranged from 50nm to 1500nm, or the silver-coated copper particles have diameters ranged from 1µm to 10µm, or a proportion of silver in the silver-coated copper particles ranges from 15% to 50%.

9. A method for manufacturing solar cells, comprising:
providing a substrate (100) including a first surface (110) and a second surface (120), wherein the first surface (110) and the second surface (120) are opposite to each other and each substantially perpendicular to a thickness direction (Z) of the substrate (100); and
forming grid lines (101) arranged at intervals on at least one of the first surface (110) and the second surface (120) along a first direction (X), wherein each grid line (101) of at least some of the grid lines (101) includes a respective contact structure (102) and a respective connection layer (103) that are electrically connected to the substrate (100), the respective contact structure (102) includes a plurality of contact portions (112) arranged at intervals along a second direction (Y), the respective connection layer (103) is an elongated strip structure extending along the second direction (Y), and the first direction (X) intersects with the second direction (Y);
wherein the respective connection layer (103) is electrically connected to the plurality of contact portions (112) and includes a material that is different from a material of the plurality of contact portions (112), and an orthographic projection of the respective connection layer (103) on the substrate (100) partially overlaps with orthographic projections of the plurality of contact portions (112) on the substrate (100);
wherein the plurality of contact portions (112) include first contact portions (122) and second contact portions (132) alternately arranged along the second direction (Y), and the respective connection layer (103) has a first side extending along the second direction (Y), an opposing second side extending along the second direction (Y), a first side portion (113) extending along the second direction (Y) on the first side, and a second side portion (123) extending along the second direction (Y) on the second side; and
wherein the first contact portions (122) traverses at least the first side portion (113), and the second contact portions (132) traverses at least the second side portion (123).

10. The method according to claim 9, wherein the grid lines (101) are finger electrodes (104), and the second surface (120) includes first printing areas and second printing areas that are partially overlapped with the first printing areas;
wherein forming the grid lines (101), includes:
printing first paste on the first printing areas using a first screen printing process;
performing sintering on the first paste to form the respective contact structure (102) on the first printing areas;
printing second paste on the second printing areas using a second screen printing process; and
curing the second paste to form the respective connection layer (103) on the second printing areas;
wherein the first paste is firing-through paste, the second paste is non-firing paste, and a process temperature for performing the sintering is greater than a process temperature for curing.

11. The method according to claim 10, wherein the first paste is silver paste, and the second paste is copper paste or silver-coated copper paste; and
wherein a solid content in the silver paste ranges from 75% to 92%.

12. The method according to claim 10, wherein the second surface (120) further includes third printing areas;
the method further includes:
printing the first paste on the third printing areas using the first screen printing process, and performing the sintering on the first paste to form busbars (105) on the third printing areas; or
printing the second paste on the third printing areas using the second screen printing process, and curing the second paste to form the busbars (105) on the third printing areas.

13. The method according to claim 12, wherein the finger electrodes (104) formed on the second surface (120) are back finger electrodes, the busbars (105) formed on the second surface (120) are back busbars, and the first surface (110) includes fourth printing areas extending along the first direction (X) and fifth printing areas extending along the second direction (Y);
before performing the sintering, the method further includes:
printing third paste on the fourth printing areas using a third screen printing process; and
printing fourth paste on the fifth printing areas using a fourth screen printing process;
wherein performing the sintering, includes:
performing the sintering on the third paste to form front finger electrodes on the fourth printing areas; and
performing the sintering on the fourth paste to form front busbars on the fifth printing areas.

14. A tandem solar cell, including:
a bottom solar cell (106), wherein the bottom solar cell (106) includes the solar cell according to any one of claims 1 to 8, or the bottom solar cell (106) is manufactured using the method according to any one of claims 9 to 13; and
a top solar cell (107) arranged on a side of the bottom solar cell (106).

15. A photovoltaic module, including:
at least one solar cell string, wherein the at least one solar cell string is formed by connecting a plurality of solar cells (40) according to any one of claims 1 to 8, or formed by connecting a plurality of solar cells (40) manufactured using the method according to any one of claims 9 to 13, or formed by connecting a plurality of tandem solar cells according to claim 14;
at least one packaging adhesive film (41) configured to cover a surface of the at least one solar cell string; and
at least one cover plate (42) configured to cover a surface of the at least one packaging adhesive film (41) away from the at least one solar cell string.
